**Europäisches Patentamt**

**European Patent Office**

**Office européen des brevets**

(19)

(11) Veröffentlichungsnummer : **0 032 728**
**B1**

(12) # EUROPÄISCHE PATENTSCHRIFT

(45) Veröffentlichungstag der Patentschrift :
**23.05.84**

(21) Anmeldenummer : **81100276.5**

(22) Anmeldetag : **15.01.81**

(51) Int. Cl.³ : **H 01 L 21/52**, H 01 L 21/60, H 01 L 23/48

(54) **Verfahren zum Einbau einer Halbleitervorrichtung in ein Gehäuse.**

(30) Priorität : **17.01.80 DE 3001613**

(43) Veröffentlichungstag der Anmeldung :
**29.07.81 Patentblatt 81/30**

(45) Bekanntmachung des Hinweises auf die Patenterteilung : **23.05.84 Patentblatt 84/21**

(84) Benannte Vertragsstaaten :
**FR GB IT**

(56) Entgegenhaltungen :
**US-A- 2 774 747**
**US-A- 2 856 681**
**US-A- 3 896 544**
**US-A- 3 942 244**
**IBM TECHNICAL DISCLOSURE BULLETIN, Band 13, Nr. 5, Oktober 1970, NEW YORK (US) R.A. LEONARD et al.: "Chromium barrier for terminal metallurgies", Seite 1121**

(73) Patentinhaber : **SIEMENS AKTIENGESELLSCHAFT Berlin und München Wittelsbacherplatz 2 D-8000 München 2 (DE)**

(72) Erfinder : **Exner, Klaus Dieter Oskar-von-Miller-Strasse 30 D-8025 Unterhaching (DE)**

EP 0 032 728 B1

Jouve, 18, rue St-Denis, 75001 Paris, France

**Beschreibung**

Ein übliches Verfahren zum Einbau einer Halbleitervorrichtung in ein Gehäuse besteht darin, daß man die Unterseite des Halbleiterkörpers der Halbleitervorrichtung unter Vermittlung einer Metallschicht als Lot auf einem als Unterlage dienenden metallischen Gehäuseteil befestigt. Eine billigere Möglichkeit sieht anstelle der Verwendung einer metallischen Zwischenschicht die Verwendung eines aus geeignetem organischen Material bestehenden Klebers vor, der dann, z. B. unter Verwendung einer entsprechenden Temperaturbehandlung, zum Aushärten gebracht wird. Beide Möglichkeiten lassen sich auch für die Chip-Montage von aus der Basis von monokristallinem Silicium hergestellten integrierten Halbleiterschaltungen und nicht nur für den Einbau von Einzelhalbleitern einsetzen.

In der US-PS 2 774 747 ist die Möglichkeit angegeben, die einzubauende Halbleitervorrichtung unter Verwendung eines mit Silberpartikeln versetzten organischen Klebers mit einer metallischen Unterlage bleibend zu verbinden, wobei der sich infolge Aushärtung des Klebers bildende Zement zugleich eine elektrisch leitende Verbindung zwischen der Halbleitervorrichtung und der die Halbleitervorrichtung elektrisch kontaktierenden Unterlage bildet. In der US-PS 3 896 544 ist eine in einem Gehäuse untergebrachte Halbleitervorrichtung beschrieben, bei der sich zwischen der Halbleiteranordnung und dem metallischen Gehäuseboden eine Zwischenlage aus elastischem Silicongummi befindet, der Silberpartikeln enthält. Mit Hilfe einer Feder wird der Halbleiterkörper gegen die Zwischenlage und den Gehäuseboden gedrückt. Eine solche Art der Montage ist jedoch für den Einbau von integrierten Schaltungen nicht günstig.

Die vorliegende Erfindung befaßt sich nun mit einem Verfahren zum Einbau einer Halbleitervorrichtung, insbesondere einer monolithisch integrierten Halbleiterschaltung, in ein Gehäuse, bei dem der aus Silicium bestehende Halbleiterkörper der Halbleitervorrichtung unter Verwendung eines mit Silberpartikeln versetzten und aus organischem Isoliermaterial bestehenden Klebers an seiner Unterseite bleibend mit einem als Unterlage und zugleich als Wärmesenke dienenden Gehäuseteil verbunden wird.

Es ist nun Aufgabe der Erfindung, ein solches Verfahren ohne größeren technischen Aufwand so auszugestalten, daß die Ableitung der beim Betrieb in der eingebauten Halbleitervorrichtung entstehenden Wärme in erheblichem Maße verbessert wird. Außerdem soll das Verfahren für den Einbau von integrierten Schaltungen geeignet sein.

Erfindungsgemäß ist hierzu vorgesehen, daß vor dem Aufbringen des Klebers die Unterseite des Halbleiterkörpers zunächst mit einer Chromschicht und diese Chromschicht unmittelbar darauf mit einer Silberschicht bedeckt wird.

Der Wärmewiderstand $R_{th}$ eines entsprechend der Erfindung montierten Halbleitersystems ist nicht größer, als wenn es durch Auflöten oder Auflegieren auf der metallischen Unterlage befestigt wäre. Außerdem haben Dauerversuche gezeigt, daß der aufgrund des erfindungsgemäßen Verfahrens erhaltene niedrige Wärmeübergangswiderstand auch durch langdauernde Wechselbelastungen nicht zerstört wird.

Die praktische Durchführung der Erfindung geschieht bevorzugt in folgender Weise :

1. Zunächst wird der aus monokristallinem Silicium bestehende scheibenförmige Halbleiterkörper der zu montierenden Halbleitervorrichtung an der mit der Unterlage zu verbindenden Unterseite durch Schleifen soweit abgetragen, daß eine Gesamtstärke von etwa 180 μm verbleibt.

2. In einer Bedampfungsanlage wird die Rückseite des scheibenförmigen Halbleiterkörpers bei ca. 300 °C mit einer 0,1 μm starken Chromschicht versehen.

3. Unmittelbar darauf (das heißt, ohne die Bedampfungsanlage zu öffnen) wird auf die Chromschicht eine ca. 1 μm dicke Silberschicht aufgedampft. Zu bemerken ist dabei, daß man auch mit dünneren Silberschichten, z. B. einer 0,5 μm starken Silberschicht, noch ausreichend gute Ergebnisse erhält.

4. Die dann aus der Bedampfungsanlage herausgenommene Halbleitervorrichtung wird dann mittels des silberhaltigen Klebers auf dem als Unterlage vorgesehenen und aus wärmeleitendem Material bestehenden Gehäuseteil, insbesondere einer metallischen Gehäuse-Grundplatte, befestigt. Als Kleber ist insbesondere ein Silicon-Kleber (z. B. Z-Kleber) geeignet, der mit dem erforderlichen Gehalt an Silberpartikeln versehen und vor der Anwendung mit ca. 10 % eines geeigneten Lösungsmittels verdünnt wird. Unmittelbar nach dem Verkleben ist eine Wärmebehandlung bei etwa 200 °C zweckmäßig. Die Erfindung wurde vor allem unter Anwendung des im Handel befindlichen Z-Klebers, dem zum Beispiel 10 bis 70 Volumprozent an Silberteilchen zugesetzt sind, erprobt.

5. Beim Aufdampfen der beiden Metallschichten sind die Aufdampfraten und damit die Rauhigkeit der schließlich erhaltenen Oberfläche der Metallisierung auf die Größe der im Kleber vorgesehenen Silberpartikel derart abzustimmen, daß zwischen der Oberfläche der Silbermetallisierung an der Chip-Rückseite und den im Kleber anwesenden Silberteilchen ein guter Flächenkontakt gewährleistet ist. Zweckmäßig wird man deshalb einen Kleber verwenden, der mit möglichst einheitlichen Silberteilchen, insbesondere zylinderförmigen oder kugelförmigen Leitsilberteilchen versetzt ist, wobei die Teilchengröße auf die Oberflächenrauhigkeit der Silberschicht abgestimmt wird. Die Chromschicht dient dabei als Haftunterlage für die Silberschicht.

Es empfehlen sich für das Aufdampfen der Chromschicht Abscheidungsgeschwindigkeiten von $3 \cdot 10^{-5}$ mm/min bis $4 \cdot 10^{-5}$ mm/min, für das Aufdampfen der Silberschicht Aufdampfgeschwindigkeiten von $5 \cdot 10^{-5}$ mm/min und ein Kleber, der zylindrische Leitsilberteilchen von 5 μm Durchmesser und 10 μm Länge enthält.

Hinsichtlich des Standes der Technik ist zu bemerken, daß aus der US-PS 3 942 244 Elektroden für Halbleitervorrichtungen bekannt sind, wobei die Elektroden aus mehreren übereinander aufgebrachten Metallschichten bestehen. Dabei bildet die an den Halbleiter angrenzende und z. B. aus Aluminium bestehende Metallschicht mit dem Halbleitermaterial eine aus einer Legierung bestehende Schicht. Die äußere Schicht der Elektroden kann z. B. aus Silber bestehen.

Andererseits war aus « IBM Techn. Discl. Bull., Vol. 13, No 5 (October 1970, S. 1121) die Anwendung einer aus Chrom bestehenden Zwischenschicht für die Haftung einer z. B. aus einer Mischung aus Chrom und Kupfer bestehenden Elektrode auf einer miniaturisierten elektrischen Vorrichtung bekannt. Dabei soll jedoch die Zwischenschicht auch als Barriere zur Unterbindung des Eindringens von Partikeln aus der kupferhaltigen Elektrode in die zu kontaktierende Vorrichtung wirken. Sie wird deshalb so hergestellt, daß die durch Vakuumaufdampfung aufgebrachte Chromschicht zunächst einer kurzen Oxidationsbehandlung zwecks Ausfüllung von Poren in der Chromschicht und dann einem Sputterprozeß zwecks Beseitigung des überschüssigen Oxyds unterzogen wird, bevor die Cu-Cr-Elektrode auf die so entstandene Zwischenschicht aufgebracht wird.

## Ansprüche

1. Verfahren zum Einbau einer Halbleitervorrichtung, insbesondere einer monolithisch integrierten Halbleiterschaltung, in ein Gehäuse, bei dem der aus Silicium bestehende Halbleiterkörper der Halbleitervorrichtung unter Verwendung eines mit Silberpartikeln versetzten und aus organischem Isoliermaterial bestehenden Klebers an seiner Unterseite bleibend mit einem als Unterlage und zugleich als Wärmesenke dienenden Gehäuseteil verbunden wird, dadurch gekennzeichnet, daß vor dem Aufbringen des Klebers die Unterseite des Halbleiterkörpers zunächst mit einer Chromschicht und diese Chromschicht unmittelbar darauf mit einer Silberschicht bedeckt wird.

2. Verfahren nach Anspruch 1, dadurch gekennzeichnet, daß die Stärke des Halbleiterkörpers der einzubauenden Halbleitervorrichtung durch eine Schleifbehandlung an seiner Rückseite, z. B. auf 180 μm, reduziert wird, daß dann in einer Bedampfungsanlage eine Chromschicht von beispielsweise 0,1 μm und auf die Chromschicht eine Silberschicht von beispielsweise 1 μm aufgebracht wird.

3. Verfahren nach Anspruch 1 oder 2, dadurch gekennzeichnet, daß als Kleber ein Siliconkleber verwendet wird.

4. Verfahren nach einem der Ansprüche 1 bis 3, dadurch gekennzeichnet, daß der Silbergehalt des Klebers auf mindestens 50 Volumprozent eingestellt wird.

5. Verfahren nach einem der Ansprüche 1 bis 4, dadurch gekennzeichnet, daß ein Kleber verwendet wird, dessen Silbergehalt durch einander gleiche Silberpartikel, insbesondere von zylindrischer oder kugelförmiger Gestelt, gebildet ist.

## Claims

1. A method of mounting a semiconductor device, in particular a monolithically integrated semiconductor circuit, in a housing, in which, using an adhesive consisting of an organic insulating material admixed with silver particles, the semiconductor body (which consists of silicon) of the semiconductor device, has its underside permanently joined to a part of the housing which serves as a support and at the same time as a heat sink, characterised in that, prior to the application of the adhesive, the underside of the semi-conductor body is first covered with a chromium layer and the latter is immediately covered with a silver layer.

2. A method according to Claim 1, characterised in that the thickness of the semiconductor body of the semiconductor device to be installed is reduced, for example, to 180 μm, by a grinding operation on its rear side ; that subsequently in a vapour-deposition unit, a chromium layer of, for example, 0.1 μm is applied, and a silver layer of, for example, 1 μm is applied on to the chromium layer.

3. A method according to Claim 1 or Claim 2, characterised in that as the adhesive, a silicone adhesive is used.

4. A method according to one of Claims 1 to 3, characterised in that the silver content of the adhesive is set to at least 50 percent by volume.

5. A method according to one of Claims 1 to 4, characterised in that an adhesive is used, the silver content of which is formed by identical silver particles, in particular, of cylindrical or spherical shape.

## Revendications

1. Procédé pour le montage d'un dispositif à semiconducteurs, notamment un circuit à semiconducteurs intégré monolithiquement, dans un boîtier, suivant lequel le corps semiconducteur, constitué par du silicium, du dispositif à semiconducteurs est relié de façon permanente au niveau de sa face inférieure, en utilisant une colle constituée par un matériau isolant organique et mélangée avec des particules d'argent, à une partie de boîtier servant de support et simultanément de dissipateur de chaleur, caractérisé par le fait qu'avant la mise en place de la colle, la face inférieure du corps semiconducteur est tout d'abord recouverte d'une couche de chrome et cette couche de chrome est recouverte immédiatement après par une couche d'argent.

2. Procédé suivant la revendication 1, caractérisé par le fait que l'épaisseur du corps semiconducteur du dispositif à semiconducteurs devant être monté est réduite, par un traitement de meulage au niveau de sa face arrière, par exemple jusqu'à 180 μm, qu'alors, dans une installation de dépôt par évaporation, une couche de chrome de par exemple 0,1 μ est déposée et une couche d'argent de par exemple 1 μ est déposée sur la couche de chrome.

3. Procédé suivant la revendication 1 ou 2, caractérisé par le fait qu'une colle au silicone est utilisée comme colle.

4. Procédé suivant l'une des revendications 1 à 3, caractérisé par le fait que la teneur en argent de la colle est réglée sur au moins 50 pourcents en volume.

5. Procédé suivant l'une des revendications 1 à 4, caractérisé par le fait qu'on utilise une colle dont la teneur en argent est formée par des particules d'argent identiques entre elles, notamment de forme cylindrique ou sphérique.